# EUROPEAN PATENT APPLICATION

(11) **EP 4 395 171 A1**
(43) Date of publication of application: **03.07.2024**
(21) Application number: 22880130.4
(22) Date of filing: 23.09.2022
(51) Int. Cl.: H03H 9/02, H03H 9/05, H03H 9/64

(54) **BULK ACOUSTIC WAVE RESONANCE STRUCTURE AND PREPARATION METHOD THEREFOR, AND ACOUSTIC WAVE DEVICE**

(30) Priority: 15.10.2021 US 202163262586 P
(71) Applicant: Wuhan Yanxi Micro Components Co., Ltd., Wuhan, Hubei 430205 (CN)
(72) Inventor: LIN, Re-Ching, Wuhan, Hubei 430205 (CN); ZHANG, Dapeng, Wuhan, Hubei 430205 (CN); LIAO, Pei-Chun, Wuhan, Hubei 430205 (CN); HUANG, Wei-sheng, Wuhan, Hubei 430205 (CN); KOH, Zhi Wei, Wuhan, Hubei 430205 (CN)
(74) Representative: Brevalex
(86) International application number: PCT/CN2022/121117
(87) International publication number: WO 2023/061190

(57) **Abstract**

Embodiments of the present disclosure provide a bulk acoustic wave resonance structure and a preparation method therefor, and an acoustic wave device. The bulk acoustic wave resonance structure comprises: a substrate; a reflection structure, a first electrode, a piezoelectric layer, and a second electrode, which are sequentially located on the substrate, the effective region of a resonance area being a first overlapping area; a first surrounding structure surrounding the first overlapping area, said structure comprising first protruding structures and first intermittent structures that are arranged at intervals; and the first protruding structures, which are located between the piezoelectric layer and the first electrode and/or are located between the piezoelectric layer and the second electrode, the end of each first protruding structure that is close to the first overlapping area being covered by the first electrode and/or the second electrode.

## Description

### CROSS-REFERENCE TO RELATED APPLICATIONS

The application is based on and claims priority to U.S. Provisional Patent Application No. 63/262,586 filed on October 15, 2021, the entire content of which is incorporated herein by reference in its entirety.

### TECHNICAL FIELD

The disclosure relates to the field of semiconductor technology, and in particular to a bulk acoustic wave resonance structure and a preparation method of a bulk acoustic wave resonance structure, and an acoustic wave device.

### BACKGROUND

In widely used communication devices (such as mobile telephones), acoustic wave devices using acoustic waves are generally included as filters of communication devices. As examples of acoustic wave devices, there are devices using a Surface Acoustic Wave (SAW), or devices using a Bulk Acoustic Wave (BAW), or the like. The performance of acoustic wave devices has an influence on the communication effect of the communication devices.

With the development of communication technology, how to improve the performance of acoustic wave devices while conforming to the development trend of integration and miniaturization of communication devices has become an urgent problem.

### SUMMARY

In a first aspect, an embodiment of the disclosure provides a bulk acoustic wave resonance structure. The bulk acoustic wave resonance structure includes:
a substrate;
a reflection structure, a first electrode, a piezoelectric layer and a second electrode that are sequentially located on the substrate; herein an effective region of a resonance region is a first overlapping region; and
a first surrounding structure that surrounds the first overlapping region, herein the first surrounding structure includes first protruding structures and first intermittent structures that are arranged at intervals.

Here, the first protruding structures are located between the piezoelectric layer and the first electrode, and/or, between the piezoelectric layer and the second electrode; and an end (adjacent to the first overlapping region) of each of the first protruding structures is covered by the first electrode and/or the second electrode.

In a second aspect, an embodiment of the disclosure provides an acoustic wave device. The acoustic wave device includes the bulk acoustic wave resonance structure according to the above embodiment.

In a third aspect, an embodiment of the disclosure provides a preparation method of a bulk acoustic wave resonance structure. The method includes the following operations.

A substrate is provided, and a sacrificial layer is formed on a surface of the substrate.

A first electrode covering the sacrificial layer and a piezoelectric layer are formed.

A protruding material layer is formed on a side (remote from the substrate) of the piezoelectric layer.

A second electrode covering the protruding material layer is formed. Here, an effective region of a resonance region is a first overlapping region.

The second electrode and the protruding material layer at an edge of the first overlapping region are etched, to form first protruding structures and first intermittent structures that are arranged at intervals. Here, the first protruding structures and the first intermittent structures form a first surrounding structure that surrounds the first overlapping region; and an end (adjacent to the first overlapping region) of each of the first protruding structures is covered by the second electrode.

At least one etch hole is formed, and the sacrificial layer is removed through the etch hole to form a reflection structure.

In a fourth aspect, an embodiment of the disclosure provides a preparation method of a bulk acoustic wave resonance structure. The method includes the following operations.

A substrate is provided, and a sacrificial layer is formed on a surface of the substrate.

A first electrode covering the sacrificial layer is formed.

A protruding material layer is formed on the first electrode.

A piezoelectric layer covering the protruding material layer and the first electrode is formed.

A second electrode covering the piezoelectric layer is formed. Here, an effective region of a resonance region is a first overlapping region.

The second electrode, the piezoelectric layer, and the protruding material layer at an edge of the first overlapping region are etched, to form first protruding structures and first intermittent structures that are arranged at intervals. Here, the first protruding structures and the first intermittent structures form a first surrounding structure that surrounds the first overlapping region; and an end (adjacent to the first overlapping region) of each of the first protruding structures is covered by the first electrode.

At least one etch hole is formed, and the sacrificial layer is removed through the etch hole to form a reflection structure.

In a fifth aspect, an embodiment of the disclosure provides a preparation method of a bulk acoustic wave resonance structure. The method includes the following operations.

A substrate is provided, and a sacrificial layer is formed on a surface of the substrate.

A first electrode covering the sacrificial layer and a piezoelectric layer are formed.

Sacrificial material structures and first intermittent structures that are arranged at intervals are formed on a side (remote from the substrate) of the piezoelectric layer,.

A second electrode covering the sacrificial material structures and the first intermittent structures is formed. Here, an effective region of a resonance region is a first overlapping region.

At least one etch hole is formed, and the sacrificial material structures and the sacrificial layer are removed through the etch hole, to form first protruding structures and a reflection structure respectively. Here, the first protruding structures and the first intermittent structures form a first surrounding structure that surrounds the first overlapping region; and an end (adjacent to the first overlapping region) of each of the first protruding structures is covered by the second electrode.

### BRIEF DESCRIPTION OF THE DRAWINGS

In the drawings, unless otherwise specified, the same reference numerals throughout multiple drawings indicates the same or similar components or elements. These drawings are not necessarily drawn to scale. It is to be understood that these drawings only depict some implementation modes disclosed according to the disclosure and should not be regarded as limitation of the scope of the disclosure.
FIG. 1 is a schematic top view of a bulk acoustic wave resonance structure according to an embodiment of the disclosure.
FIG. 2 is a first sectional schematic diagram of a bulk acoustic wave resonance structure according to an embodiment of the disclosure.
FIG. 3 is a second sectional schematic diagram of a bulk acoustic wave resonance structure according to an embodiment of the disclosure.
FIG. 4 is a schematic top view of another bulk acoustic wave resonance structure according to an embodiment of the disclosure.
FIG. 5 is a third sectional schematic diagram of a bulk acoustic wave resonance structure according to an embodiment of the disclosure.
FIG. 6 is a fourth sectional schematic diagram of a bulk acoustic wave resonance structure according to an embodiment of the disclosure.
FIG. 7 is a schematic top view of yet another bulk acoustic wave resonance structure according to an embodiment of the disclosure.
FIG. 8 is a fifth sectional schematic diagram of a bulk acoustic wave resonance structure according to an embodiment of the disclosure.
FIG. 9 is a sixth sectional schematic diagram of a bulk acoustic wave resonance structure according to an embodiment of the disclosure.
FIG. 10 is a seventh sectional schematic diagram of a bulk acoustic wave resonance structure according to an embodiment of the disclosure.
FIG. 11 is an eighth sectional schematic diagram of a bulk acoustic wave resonance structure according to an embodiment of the disclosure.
FIG. 12 is a ninth sectional schematic diagram of a bulk acoustic wave resonance structure according to an embodiment of the disclosure.
FIG. 13 is a tenth sectional schematic diagram of a bulk acoustic wave resonance structure according to an embodiment of the disclosure.
FIG. 14 is an eleventh sectional schematic diagram of a bulk acoustic wave resonance structure according to an embodiment of the disclosure.
FIG. 15 is a twelfth sectional schematic diagram of a bulk acoustic wave resonance structure according to an embodiment of the disclosure.
FIG. 16 is a thirteenth sectional schematic diagram of a bulk acoustic wave resonance structure according to an embodiment of the disclosure.
FIG. 17 is a fourteenth sectional schematic diagram of a bulk acoustic wave resonance structure according to an embodiment of the disclosure.
FIG. 18 is a fifteenth sectional schematic diagram of a bulk acoustic wave resonance structure according to an embodiment of the disclosure.
FIG. 19 is a sixteenth sectional schematic diagram of a bulk acoustic wave resonance structure according to an embodiment of the disclosure.
FIG. 20 is a seventeenth sectional schematic diagram of a bulk acoustic wave resonance structure according to an embodiment of the disclosure.
FIG. 21 is a flowchart of a preparation method of a bulk acoustic wave resonance structure according to an embodiment of the disclosure.
FIG. 22a to FIG. 22d are first sectional schematic diagrams of a process of a preparation method of a bulk acoustic wave resonance structure according to an embodiment of the disclosure.
FIG. 23a to FIG. 23d are second sectional schematic diagrams of a process of a preparation method of a bulk acoustic wave resonance structure according to an embodiment of the disclosure.
FIG. 24 is a schematic diagram of a Smith Circle test result of a bulk acoustic wave resonance structure according to an embodiment of the disclosure.
FIG. 25 is a schematic diagram of another Smith Circle test result of a bulk acoustic wave resonance structure according to an embodiment of the disclosure.

### DETAILED DESCRIPTION

The technical solutions of the disclosure are described below in detail in combination with the drawings of the description and specific embodiments.

In the embodiments of the disclosure, the terms "first", "second" or the like are used to distinguish similar objects, and are not used to describe a particular order or sequence.

In the embodiments of the disclosure, the term "A is in contact with B" includes a case where A is in direct contact with B, or a case where A is in indirectly contact with B with other components interposed between A and B.

In the embodiments of the disclosure, the term "layer" refers to a material part including a region with a thickness. A layer may extend on the entirety of an upper structure or a lower structure, or may have a scope that is smaller than the scope of the upper structure or the lower structure. In addition, a layer may be a region of a homogeneous or non-homogeneous continuous structure that a thickness of the layer is less than the thickness of a continuous structure. For example, a layer may be located between the top surface and the bottom surface of a continuous structure, or a layer may be located between any pair of horizontal planes at the top surface and bottom surface of the continuous structure. A layer may extend horizontally, vertically, and/or along an inclined surface. Further, a layer may include multiple sub-layers.

It is to be understood that the terms "on" "above" and "over" in the disclosure should be interpreted in the broadest manner such that "on" not only denotes "on" something without any intervening feature or layer (i.e., directly on something), but also "on" something with an intervening feature or layer.

Resonator includes dielectric resonator, surface acoustic wave resonator, and bulk acoustic wave resonator. The large power capacity of dielectric resonator is the advantage of this technology, but the large size can not satisfy the development of chip miniaturization and integration well. In addition, currently in the field of mobile communication, frequency difference between different frequency bands is getting smaller, which makes higher requirements on signal selectivity of the filter, and thus devices are required to have a higher quality factor (Q value).

Surface acoustic wave resonator has been widely used in commercial products due to higher operating frequency, low phase noise, high Q value, lower insertion loss, and simple preparation process below 2GHz frequency band. However, with the development of 5G communication, the application of surface acoustic wave resonator in the field of high-frequency communication has been limited due to the size limitation of interdigitated electrodes.

The resonance frequency of a bulk acoustic wave resonator depends on various factors, such as the piezoelectric material, different production methods, and the influence of the manufacturing process, especially the material thickness of the piezoelectric material. Bulk acoustic wave resonator may achieve an operating frequency far higher than an operating frequency of surface acoustic wave resonator, and the size shrinks as the frequency increases. Therefore, bulk acoustic wave resonator has an advantage of smaller size, and play an important role in the field of communication. The Film Bulk Acoustic Resonator (FBAR), as a branch of bulk acoustic wave resonator, has been greatly improved with the development of communication technology, and the related filter and duplexer have achieved a commercial large-scale application in the field of high-frequency communication.

There are many parameters to measure the performance of a film bulk acoustic resonator, and the main parameter includes the quality factor (Q value). When electrical energy is applied to the upper and lower electrodes of a bulk acoustic wave resonator, the piezoelectric layers located in the upper and lower electrodes generate acoustic waves due to the piezoelectric effect. In addition to longitudinal waves, transverse shear waves (also referred to as lateral waves or shear waves) are generated in the piezoelectric layers. The presence of transverse shear waves affects the energy of the main longitudinal waves, and the transverse shear waves cause energy loss and deteriorate the Q value of the bulk acoustic wave resonator.

For example, in a mobile terminal, there is a case where multiple frequency bands are used simultaneously, which requires the filter or duplexer in the mobile terminal to have steeper skirts and less insertion loss. The performance of a filter is determined by the resonator that constitutes the filter, and increasing the Q value of the resonator may achieve steeper skirts and less insertion loss. In addition, excessive parasitic resonance of the resonator may adversely affect the performance of the filter or duplexer.

In view of this, how to reduce the parasitic resonance of the bulk acoustic wave resonator and improve the Q value of the bulk acoustic wave resonator has become an urgent problem.

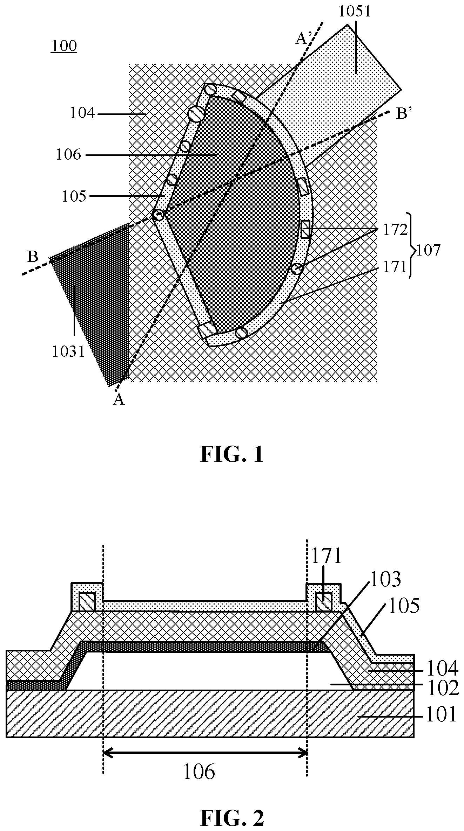

FIG. 1 is a schematic top view of a bulk acoustic wave resonance structure 100 according to an embodiment of the disclosure, and FIG. 2 is a sectional schematic diagram of the bulk acoustic wave resonance structure 100 illustrated according to FIG. 1 along the AA' direction. Referring to FIG. 2, the bulk acoustic wave resonance structure 100 includes:
a substrate 101;
a reflection structure 102, a first electrode 103, a piezoelectric layer 104 and a second electrode 105 that are sequentially located on the substrate 101; herein an effective region of a resonance region is a first overlapping region 106; and
a first surrounding structure 107 that surrounds the first overlapping region 106, herein the first surrounding structure 107 includes first protruding structures 171 and first intermittent structures 172 that are arranged at intervals.

Here, the first protruding structures 171 are located between the piezoelectric layer 104 and the first electrode 103, and/or, between the piezoelectric layer 104 and the second electrode 105; and an end (adjacent to the first overlapping region 106) of each of the first protruding structures 171 is covered by the first electrode 103 and/or the second electrode 105.

It is to be noted that in order to make it easy to visually describe the position of each portion of the first surrounding structure 107, the bulk acoustic wave resonance structure 100 illustrated in FIG. 2 is a local sectional schematic diagram highlighting the first surrounding structure 107. The bulk acoustic wave resonance structure illustrated in FIG. 2 is only an example of the embodiments of the disclosure and is not used to limit the features of the bulk acoustic wave resonance structure in the embodiments of the disclosure. Other examples of the bulk acoustic wave resonance structure of the embodiments of the disclosure are further illustrated in later embodiments. In FIG. 2, the case where the first protruding structure 171 is located between the piezoelectric layer 104 and the second electrode 105 is illustrated as an example.

In a practical application, the composition material of the substrate 101 may include silicon (Si), germanium (Ge), or the like.

Exemplarily, the first electrode 103 may be referred to as a lower electrode, and correspondingly, the second electrode 105 may be referred to as an upper electrode. Electrical energy may be applied to the bulk acoustic wave resonance structure 100 through the upper electrode and lower electrode. The composition materials of the first electrode 103 and the second electrode 105 may be the same, and the composition material may include conductive metals such as aluminum (Al), molybdenum (Mo), ruthenium (Ru), iridium (Ir), chromium (Cr), or platinum (Pt), or conductive materials consisting of alloys of the above conductive metals. Exemplarily, the composition materials of the first electrode 103 and the second electrode 105 are both molybdenum (Mo).

In a practical application, the piezoelectric layer 104 may be used to generate vibrations according to inverse piezoelectric characteristics, and convert electrical signals applied to the first electrode 103 and the second electrode 105 into acoustic wave signals, which realizes the conversion from electrical energy to mechanical energy.

Exemplarily, the composition material of the piezoelectric layer 104 includes a material having piezoelectric characteristics, for example, aluminum nitride, zinc oxide, lithium tantalate, lead zirconate titanate, barium titanate, or the like. The composition material of the piezoelectric layer 104 may further include a material having piezoelectric characteristics by doping, which may be doped with a transition metal or a rare metal, for example, scandium-doped aluminum nitride, or the like.

Here, the reflection structure 102 is used to reflect acoustic wave signals. When an acoustic wave signal generated by the piezoelectric layer 104 propagates toward the reflection structure 102, the acoustic wave signal may be totally reflected at the interface where the first electrode 103 and the reflection structure 102 are in contact, to able the acoustic wave signal to be reflected back into the piezoelectric layer 104. In this way, the energy of the acoustic wave signals generated by the piezoelectric layer 104 can be confined within the piezoelectric layer 104, thereby reducing energy loss of acoustic wave signals and increasing acoustic wave energy of the main resonance mode of the bulk acoustic wave resonance structure.

It is to be noted that the bulk acoustic wave resonance structure illustrated in FIG. 2 is only an example provided by the disclosure. In a practical application, according to different forms of the reflection structure 102, bulk acoustic wave resonance structures may be specifically classified as: a first type of cavity-type FBAR, a second type of cavity-type FBAR, a Solid Mounted Resonator (SMR), or the like. The solutions provided by the embodiments of the disclosure may apply to the above different types of the bulk acoustic wave resonance structure.

Exemplarily, in case that the bulk acoustic wave resonance structure includes a first type of cavity-type FBAR, the reflection structure 102 includes a first cavity formed between the upwardly protruded first electrode 103 and the surface of the substrate 101. In case that the bulk acoustic wave resonance structure 100 includes a second type of cavity-type FBAR, the reflection structure 102 includes a second cavity formed between the downwardly recessed surface of the substrate 101 and the first electrode 103. Here, the case where the bulk acoustic wave resonance structure 100 includes a first type of cavity-type FBAR is illustrated as an example.

In a practical application, as illustrated in FIG. 2, the resonance region is an overlapping region of an orthographic projection of the reflection structure 102 on the substrate 101, an orthographic projection of the first electrode 103 on the substrate 101, an orthographic projection of the piezoelectric layer 104 on the substrate 101, and an orthographic projection of the second electrode 105 on the substrate. Here, the effective region (or the main resonance region) of the resonance region is the first overlapping region 106, and the main resonance mode of the bulk acoustic wave resonance structure is generated within the first overlapping region 106.

Referring to FIG. 1, the first surrounding structure 107 includes first protruding structures 171 and first intermittent structures 172 that are arranged at intervals. It is to be noted that in FIG. 1, the first protruding structures 171 are covered by the second electrode 105, and the first protruding structures 171 are not shown in perspective. As illustrated in FIG. 1, the first protruding structures 171 arranged at intervals are set close to the edge of the first overlapping region 106, and the first protruding structures 171 surround the first overlapping region 106.

Exemplarily, as illustrated in FIG. 2, the first protruding structures 171 are located between the piezoelectric layer 104 and the second electrode 105, and an end (adjacent to the first overlapping region 106) of each first protruding structure 171 is covered by the second electrode 105. The first protruding structure 171 is set to able that the distance from the second electrode 105 to the first electrode 103 along the direction perpendicular to the substrate 101 becomes longer within the range of the orthographic projection of the first protruding structure 171. In this way, the electric field line from the second electrode 105 to the first electrode 103 becomes longer, such that the electric field intensity close to the edge of the first overlapping region 106 becomes lower. Since the electric field intensity becomes lower, the electric displacement is reduced and the effect of piezoelectric resonance becomes lower, such that the parasitic resonance close to the edge of the first overlapping region 106 (i.e., which may be inside the first overlapping region 106 or outside the first overlapping region 106) is reduced to reduce the propagation of the parasitic resonance to the first overlapping region, thereby improving the Q value of the bulk acoustic wave resonance structure.

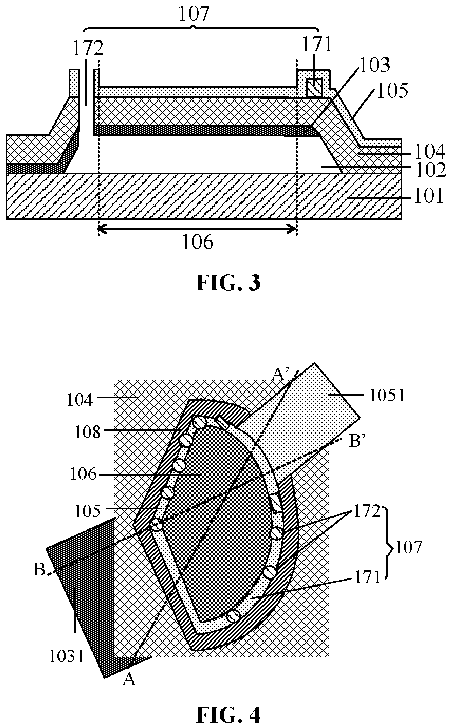

FIG. 3 is a local sectional schematic diagram of the bulk acoustic wave resonance structure 100 illustrated according to FIG. 1 along the BB' direction. Exemplarily, as illustrated in FIG. 3, the first intermittent structure 172 may be a groove that penetrates through the second electrode 105, the first protruding structure 171, the piezoelectric layer 104, and the first electrode 103. The first intermittent structures 172 that are set around the first overlapping region 106 may reflect transverse shear waves in the first overlapping region 106, such that energy is concentrated in longitudinal waves in the first overlapping region 106 to suppress the transverse parasitic modes (i.e., suppress the parasitic resonance) and improve the quality factor (Q value).

It is to be noted that in some embodiments, the first protruding structures 171 of the bulk acoustic wave resonance structure may be only located on the slope of the piezoelectric layer 104 (which is not shown).

In the embodiment, a first surrounding structure 107 surrounding the first overlapping region 106 is set, and the first surrounding structure 107 includes first protruding structures 171 and first intermittent structures 172 that are arranged at intervals. In this way, the distance between the second electrode 105 and the first electrode 103 at the edge of the first overlapping region 106 may be increased, thereby reducing the electric field intensity at the edge of the first overlapping region 106. Since the electric field intensity is reduced, the electric displacement is reduced and the effect of piezoelectric resonance becomes lower, which can reduce the parasitic resonance at the edge of the first overlapping region 106 to reduce the propagation of the parasitic resonance to the first overlapping region 106, thereby improving the Q value of the bulk acoustic wave resonance structure. In addition, the first intermittent structures 172 that are set around the first overlapping region 106 can reflect transverse shear waves in the first overlapping region 106, such that energy is concentrated in longitudinal waves in the first overlapping region 106 to suppress the transverse parasitic modes (i.e., suppress the parasitic resonance) and improve the quality factor (Q value).

In some embodiments, referring to FIG. 4, in case that the first protruding structures 171 are only located between the piezoelectric layer 104 and the second electrode 105, the bulk acoustic wave resonance structure further includes a second surrounding structure 108 that surrounds the first surrounding structure 107.

The second surrounding structure 108 partially covers a sidewall (remote from the reflection structure 102) of the piezoelectric layer 104.

Referring to FIG. 4, the first surrounding structure 107 includes first protruding structures 171 and first intermittent structures 172 that are arranged at intervals. It is to be noted that in FIG. 4, the first protruding structures 171 are covered by the second electrode 105, and the first protruding structures 171 are not shown in perspective. As illustrated in FIG. 4, the first protruding structures 171 arranged at intervals are set close to the edge of the first overlapping region 106, the first protruding structures 171 surround the first overlapping region 106, and the second surrounding structure 108 surrounds the first surrounding structure 107.

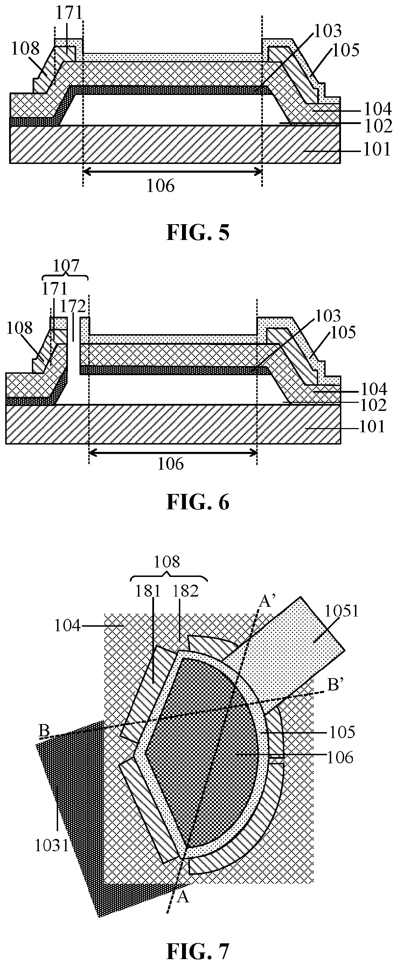

Exemplarily, FIG. 5 is a local sectional schematic diagram of the bulk acoustic wave resonance structure illustrated according to FIG. 4 along the AA' direction. As illustrated in FIG. 5, the first protruding structure 171 is located between the piezoelectric layer 104 and the second electrode 105, and an end (adjacent to the first overlapping region 106) of each first protruding structure 171 is covered by the second electrode 105. The second surrounding structure 108 is connected to the first protruding structure 171, and the second surrounding structure 108 has an inclination angle with respect to the surface of the substrate 101. Exemplarily, the inclination angle of the second surrounding structure 108 ranges from 10° to 80°. The inclination angle may also be improved according to the design dimension of the bulk acoustic wave resonance structure. The second surrounding structure 108 and the first protruding structure 171 form a protruding structure close to the first overlapping region 106. The second surrounding structure 108 and the first protruding structure 171 are set such that the distance from the second electrode 105 to the first electrode 103 along the direction perpendicular to the substrate 101 becomes longer within the range of the orthographic projection of the second surrounding structure 108 and the first protruding structure 171. In this way, the electric field line from the second electrode 105 to the first electrode 103 becomes longer, such that the electric field intensity close to the first overlapping region 106 becomes lower. Since the electric field intensity becomes lower, the electric displacement is reduced and the effect of piezoelectric resonance becomes lower, such that the parasitic resonance close to the edge of the first overlapping region 106 (i.e., which may be inside the first overlapping region or outside the first overlapping region) is reduced to reduce the propagation of the parasitic resonance to the first overlapping region, thereby improving the Q value of the bulk acoustic wave resonance structure.

In an embodiment, the composition materials of the second surrounding structure 108 and the first protruding structure 171 are the same, for example, the composition material of the second surrounding structure 108 and the first protruding structure 171 includes silicon dioxide (SiO₂). In another embodiment, the composition materials of the second surrounding structure 108 and the first protruding structure 171 are different, for example, the composition material of the second surrounding structure 108 includes silicon dioxide (SiO₂), and the composition material of the first protruding structure 171 includes silicon carbide (SiC).

FIG. 6 is a local sectional schematic diagram of the bulk acoustic wave resonance structure illustrated according to FIG. 4 along the BB' direction. Exemplarily, as illustrated in FIG. 6, the first intermittent structure 172 may be a groove that penetrates through the second electrode 105, the first protruding structure 171, the piezoelectric layer 104, and the first electrode 103. The first intermittent structures 172 that are set around the first overlapping region 106 may reflect transverse shear waves in the first overlapping region 106, such that energy is concentrated in longitudinal waves in the first overlapping region 106 to suppress the transverse parasitic modes (i.e., suppress the parasitic resonance) and improve the quality factor (Q value).

In the embodiment, by setting a first surrounding structure 107 and a second surrounding structure 108 surrounding the first overlapping region 106, the distance between the first electrode 103 and the second electrode 105 at the edge of the first overlapping region 106 is further increased, and the parasitic resonance at the edge of the first overlapping region 106 is reduced to reduce the propagation of the parasitic resonance to the first overlapping region 106, thereby improving the Q value of the bulk acoustic wave resonance structure.

In some embodiments, referring to FIG. 5, materials of the second surrounding structure 108 and the first protruding structure 171 are the same, and the second surrounding structure 108 is connected to the first protruding structure 171 to form an integral structure.

Exemplarily, the composition materials of the second surrounding structure 108 and the first protruding structure 171 are the same, for example, the composition material of the second surrounding structure 108 and the first protruding structure 171 includes silicon dioxide (SiO₂), or the composition material of the second surrounding structure 108 and the first protruding structure 171 includes silicon carbide (SiC) or aluminum nitride (AIN), which is not limited by the disclosure.

It is to be noted that the second surrounding structure 108 is connected to the first protruding structure 171 to form an integral structure, and the integral structure is a protruding structure close to the first overlapping region 106. As illustrated in FIG. 5, the first protruding structure 171 in the protruding structure is covered by the second electrode 105, and the second surrounding structure 108 in the protruding structure is located on the slope of the piezoelectric layer 104 and is not covered by the second electrode 105.

In some embodiments, referring to FIG. 7, the second surrounding structure 108 includes second protruding structures 181 and second intermittent structures 182 that are arranged at intervals. The first intermittent structures 172 and the second intermittent structures 182 are gaps. Materials of the second protruding structures 181 and the first protruding structures 171 are the same, and each of the second protruding structures 181 is connected to a respective first protruding structure 171 to form an integral structure.

It is to be noted that in FIG. 7, the first protruding structures 171 and the first intermittent structures 172 (not shown) are covered by the second electrode 105, and the second electrode 105 is shown in perspective. The first protruding structure 171 and the first intermittent structure 172 that are arranged at intervals are set close to the edge of the first overlapping region 106. The second surrounding structure 108 surrounds the first surrounding structure 107 (not shown), and in FIG. 7, the first surrounding structure 107 is covered by the second electrode 105. The second surrounding structure 108 includes second protruding structures 181 and second intermittent structures 182 that are arranged at intervals.

As illustrated in FIG. 7, the first intermittent structures 172 and the second intermittent structures 182 are gaps. The gaps that are set around the first overlapping region 106 may reflect transverse shear waves in the first overlapping region 106, such that energy is concentrated in longitudinal waves in the first overlapping region 106 to suppress the transverse parasitic modes (i.e., suppress the parasitic resonance) and improve the Q value.

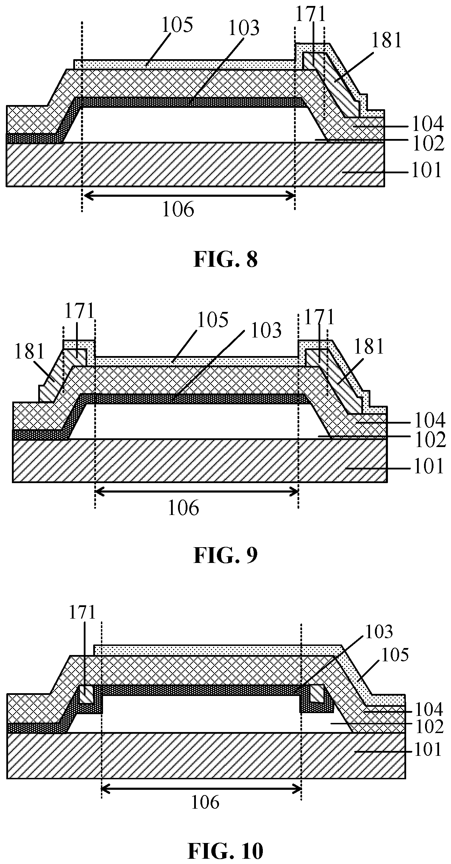

FIG. 8 is a local sectional schematic diagram of the bulk acoustic wave resonance structure illustrated according to FIG. 7 along the AA' direction. As illustrated in FIG. 8, the first protruding structure 171 is located between the piezoelectric layer 104 and the second electrode 105, the first protruding structure 171 is covered by the second electrode 105, and the second protruding structure 181 is covered by an upper electrode lead connected to the second electrode 105. The second protruding structure 181 is connected to the first protruding structure 171, and the second protruding structure 181 has an inclination angle with respect to the surface of the substrate 101. Exemplarily, the inclination angle of the second protruding structure 181 ranges from 10° to 80°. The inclination angle may also be improved according to the design dimension of the bulk acoustic wave resonance structure.

Referring to FIG. 8, the materials of the second protruding structure 181 and the first protruding structure 171 are the same, and the second protruding structure 181 is connected to the first protruding structure 171 to form an integral structure. Exemplarily, the composition material of the second protruding structure 181 and the first protruding structure 171 includes silicon dioxide (SiO₂). The second protruding structure 181 and the first protruding structure 171 form a protruding structure close to the first overlapping region 106. The second protruding structure 181 and the first protruding structure 171 are set such that the distance from the second electrode 105 to the first electrode 103 along the direction perpendicular to the substrate 101 becomes longer within the range of the orthographic projection of the second protruding structure 181 and the first protruding structure 171. In this way, the electric field line from the second electrode 105 to the first electrode 103 becomes longer, such that the electric field intensity close to the first overlapping region 106 becomes lower. Since the electric field intensity becomes lower, the electric displacement is reduced and the effect of piezoelectric resonance becomes lower, such that the parasitic resonance close to the edge of the first overlapping region 106 (i.e., which may be inside the first overlapping region or outside the first overlapping region) is reduced to reduce the propagation of the parasitic resonance to the first overlapping region, thereby improving the Q value of the bulk acoustic wave resonance structure.

FIG. 9 is a local sectional schematic diagram of the bulk acoustic wave resonance structure illustrated according to FIG. 7 along the BB' direction. Exemplarily, as illustrated in FIG. 9, the first protruding structures 171 are located between the piezoelectric layer 104 and the second electrode 105, and an end (adjacent to the first overlapping region 106) of each first protruding structure 171 is covered by the second electrode 105. The second protruding structure 181 is partially covered by an upper electrode lead connected to the second electrode 105, and the second protruding structure 181 is partially not covered by the second electrode 105.

Compared to the bulk acoustic wave resonance structure illustrated in FIG. 4, in the embodiment, the bulk acoustic wave resonance structure illustrated according to FIG. 7 includes intermittent protruding structures, and there is no need to form a groove by etching, which may reduce the etching steps and save the cost in the preparation process.

In some embodiments, referring to FIG. 2, in case that the first protruding structures 171 are only located between the piezoelectric layer 104 and the second electrode 105, the end adjacent to the first overlapping region 106 and another end remote from the first overlapping region 106 of the first protruding structure 171 are covered by the second electrode 105.

Each of the first protruding structures 171 includes a top and a bottom that are opposite in a direction perpendicular to the substrate 101, the top is in direct contact with the second electrode 105, and the bottom is in direct contact with the piezoelectric layer 104.

As illustrated in FIG. 2, the end adjacent to the first overlapping region 106 and another end remote from the first overlapping region 106 of each of the first protruding structures 171 are covered by the second electrode 105. The first protruding structure 171 is located on a side (remote from the substrate 101) of the piezoelectric layer 104 and protrudes toward a direction away from the substrate 101, therefore, the second electrode 105 covering the first protruding structures 171 protrudes toward a direction away from the substrate 101 in the direction perpendicular to the substrate 101. The first protruding structure 171 is set such that the distance from the second electrode 105 to the first electrode 103 along the direction perpendicular to the substrate 101 becomes longer within the range of the orthographic projection of the first protruding structure 171.

In the embodiment, the electric field line from the second electrode 105 to the first electrode 103 becomes longer, such that the electric field intensity close to the first overlapping region 106 becomes lower. Since the electric field intensity becomes lower, the electric displacement is reduced and the effect of piezoelectric resonance becomes lower, such that the parasitic resonance close to the edge of the first overlapping region 106 (i.e., which may be inside the first overlapping region or outside the first overlapping region) is reduced to reduce the propagation of the parasitic resonance to the first overlapping region, thereby improving the Q value of the bulk acoustic wave resonance structure.

In some embodiments, referring to FIG. 10, in case that the first protruding structures 171 are only located between the piezoelectric layer 104 and the first electrode 103:

the end (adjacent to the first overlapping region 106) and another end (remote from the first overlapping region 106) of each of the first protruding structures 171 are covered by the first electrode 103; and
each of the first protruding structures 171 includes a top and a bottom that are opposite in a direction perpendicular to the substrate 101, the top is in direct contact with the piezoelectric layer 104, and the bottom is in direct contact with the first electrode 103.

As illustrated in FIG. 10, the end adjacent to the first overlapping region 106 and another end remote from the first overlapping region 106 of each of the first protruding structures 171 are covered by the first electrode 103. The first protruding structure 171 is located on a side (close to the substrate 101) of the piezoelectric layer 104 and protrudes toward a direction close to the substrate 101, therefore, the first electrode 103 covering the first protruding structures 171 protrudes toward a direction close to the substrate 101 in the direction perpendicular to the substrate 101. The first protruding structure 171 is set such that the distance from the second electrode 105 to the first electrode 103 along the direction perpendicular to the substrate 101 becomes longer within the range of the orthographic projection of the first protruding structure 171.

In the embodiment, the electric field line from the second electrode 105 to the first electrode 103 becomes longer, such that the electric field intensity close to the first overlapping region 106 becomes lower. Since the electric field intensity becomes lower, the electric displacement is reduced and the effect of piezoelectric resonance becomes lower, such that the parasitic resonance close to the edge of the first overlapping region 106 (i.e., which may be inside the first overlapping region or outside the first overlapping region) is reduced to reduce the propagation of the parasitic resonance to the first overlapping region, thereby improving the Q value of the bulk acoustic wave resonance structure.

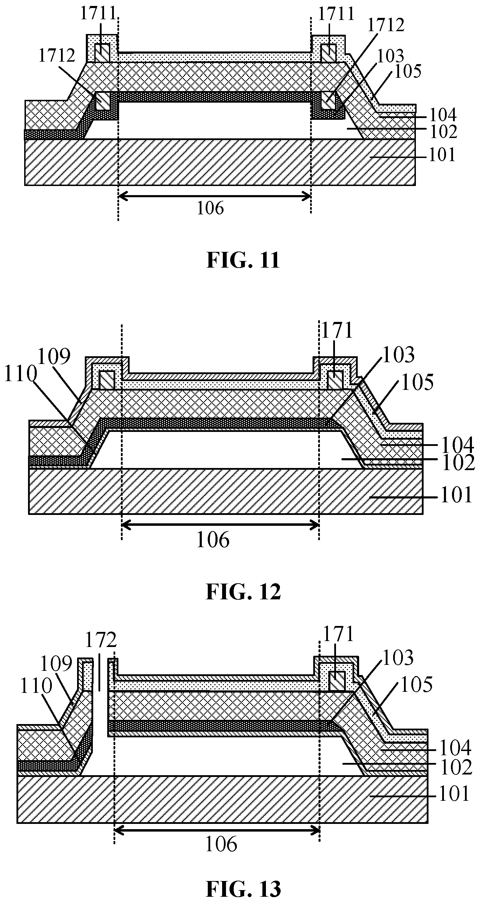

In some embodiments, referring to FIG. 11, the first protruding structure 171 includes a first substructure 1711 and a second substructure 1712.

The first substructure 1711 is only located between the piezoelectric layer 104 and the second electrode 105, and an end adjacent to the first overlapping region 106 and another end remote from the first overlapping region 106 of each first substructure 1711 are covered by the second electrode 105.

The second substructure 1712 is only located between the piezoelectric layer 104 and the first electrode 103, and an end adjacent to the first overlapping region 106 and another end remote from the first overlapping region 106 of each second substructure 1712 are covered by the first electrode 103.

The orthographic projection of the first substructure 1711 on the substrate 101 at least partially overlaps with the orthographic projection of the second substructure 1712 on the substrate 101.

As illustrated in FIG. 11, multiple first substructures 1711 are set between the piezoelectric layer 104 and the second electrode 105, and multiple second substructures 1712 are set between the piezoelectric layer 104 and the first electrode 103. In the embodiment, the case where the orthographic projection of the first substructure 1711 on the substrate 101 overlaps with the orthographic projection of the second substructure 1712 on the substrate 101, as illustrated in FIG. 11, is illustrated as an example. It is to be noted that the positions of the first substructure 1711 and the second substructure 1712 may vary, which is not limited by the disclosure.

Exemplarily, an end adjacent to the first overlapping region 106 and another end remote from the first overlapping region 106 of each of the first substructures 1711 are covered by the second electrode 105. The first substructure 1711 is located on a side remote from the substrate 101 of the piezoelectric layer 104 and protrudes toward a direction away from the substrate 101, therefore, the second electrode 105 covering the first substructures 1711 protrudes toward a direction away from the substrate 101 in the direction perpendicular to the substrate 101. The first substructure 1711 is set such that the distance from the second electrode 105 to the first electrode 103 along the direction perpendicular to the substrate 101 becomes longer within the range of the orthographic projection of the first substructure 1711. An end adjacent to the first overlapping region 106 and another end remote from the first overlapping region 106 of each of the second substructures 1712 are covered by the first electrode 103. The second substructure 1712 is located on a side close to the substrate 101 of the piezoelectric layer 104 and protrudes toward a direction close to the substrate 101, therefore, the first electrode 103 covering the second substructures 1712 protrudes toward a direction close to the substrate 101 in the direction perpendicular to the substrate 101. The second substructure 1712 is set such that the distance from the second electrode 105 to the first electrode 103 along the direction perpendicular to the substrate 101 becomes longer within the range of the orthographic projection of the second substructure 1712.

In the embodiment, by setting first substructures 1711 and second substructures 1712, the length of the electric field line from the second electrode 105 to the first electrode 103 is further increased, such that the electric field intensity close to the first overlapping region 106 becomes lower. Since the electric field intensity becomes lower, the electric displacement is reduced and the effect of piezoelectric resonance becomes lower, such that the parasitic resonance close to the edge of the first overlapping region 106 (i.e., which may be inside the first overlapping region or outside the first overlapping region) is reduced to reduce the propagation of the parasitic resonance to the first overlapping region, thereby improving the Q value of the bulk acoustic wave resonance structure.

In some embodiments, the distance between the end (adjacent to the first overlapping region 106) of the first protruding structure 171 and the edge of the first overlapping region 106 in a first direction is 0 µm to 10 µm. The first direction is a direction from the edge of the first overlapping region 106 toward the center of the first overlapping region 106.

In an example, the end (adjacent to the first overlapping region 106) of the first protruding structure 171 is flush with the edge of the first overlapping region 106, that is, the distance between the end adjacent to the first overlapping region 106 of the first protruding structure 171 and the edge of the first overlapping region 106 in the first direction is 0. In another example, as illustrated in FIG. 2, the distance between the end adjacent to the first overlapping region 106 of the first protruding structure 171 and the edge of the first overlapping region 106 in the first direction may be 5 µm. Preferably, the distance between the end adjacent to the first overlapping region 106 of the first protruding structure 171 and the edge of the first overlapping region 106 in the first direction is 0 µm.

It is to be noted that the distance between the end adjacent to the first overlapping region 106 of the first protruding structure 171 and the edge of the first overlapping region 106 in the first direction may also be improved according to the design dimensions of the bulk acoustic wave resonance structure, which is not limited by the disclosure.

In some embodiments, referring to FIG. 1, the bulk acoustic wave resonance structure further includes a first electrode lead 1031 and a second electrode lead 1051. The first electrode lead 1031 is connected to the first electrode 103, and the second electrode lead 1051 is connected to the second electrode 105.

The orthographic projection of the first electrode lead 1031 on the substrate 101 and the orthographic projection of the second electrode lead 1051 on the substrate 101 are located in a region outside the first overlapping region 106.

The orthographic projection of the first intermittent structure 172 on the substrate 101 falls into a region outside the orthographic projection of the first electrode lead 1031 on the substrate 101 and the orthographic projection of the second electrode lead 1051 on the substrate 101.

In a practical application, the bulk acoustic wave resonator further includes a first electrode lead 1031 and a second electrode lead 1051. The first electrode lead 1031 is also referred to as a lower electrode lead and the second electrode lead 1051 is also referred to as an upper electrode lead. The first electrode lead 1031 (the lower electrode lead) and the first electrode 103 (the lower electrode) are set in the same layer, and the first electrode lead 1031 is connected to the first electrode 103. The second electrode lead 1051 (the upper electrode lead) and the second electrode 105 (the upper electrode) are set in the same layer, and the second electrode lead 1051 is connected to the second electrode 105.

As illustrated in FIG. 1 or FIG. 4, the orthographic projection of the first intermittent structure 172 on the substrate 101 falls into a region outside the orthographic projection of the first electrode lead 1031 on the substrate 101 and the orthographic projection of the second electrode lead 1051 on the substrate 101.

In some embodiments, the bulk acoustic wave resonance structure further includes a frequency trimming layer 109 located on the second electrode 105.

The first surrounding structure 107 is located between the frequency trimming layer 109 and the second electrode 105.

In a practical application, the bulk acoustic wave resonance structure further includes a frequency trimming layer 109, which is also referred to as a trimming layer. The frequency trimming layer 109 may be used to adjust the frequency of the bulk acoustic wave resonance structure.

The first surrounding structure 107 includes first protruding structures 171 and first intermittent structures 172 that are arranged at intervals. In an example, as illustrated in FIG. 12, the frequency trimming layer 109 covers the second electrode 105, and the first protruding structures 171 are located between the piezoelectric layer 104 and the second electrode 105. In another example, the frequency trimming layer 109 covers the second electrode 105, and the first protruding structures 171 are located between the frequency trimming layer 109 and the second electrode 105 (not shown).

FIG. 13 is a local sectional schematic diagram of the bulk acoustic wave resonance structure illustrated according to FIG. 12 along the direction of the first intermittent structure. Exemplarily, as illustrated in FIG. 13, the first intermittent structure 172 may be a groove that penetrates through the frequency trimming layer 109, the second electrode 105, the first protruding structure 171, the piezoelectric layer 104, and the first electrode 103. The first intermittent structures 172 that are set around the first overlapping region 106 may reflect transverse shear waves in the first overlapping region 106, such that energy is concentrated in longitudinal waves in the first overlapping region 106 to suppress the transverse parasitic modes (i.e., suppress the parasitic resonance) and improve the Q value.

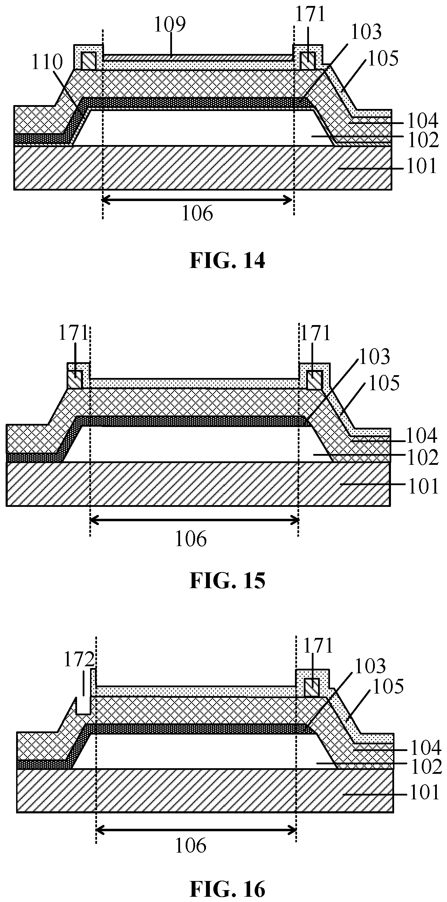

Exemplarily, as illustrated in FIG. 14, the frequency trimming layer 109 covers a portion of the second electrode 105, the orthographic projection of the frequency trimming layer 109 on the substrate 101 falls into the first overlapping region 106, and the first protruding structures 171 are located between the piezoelectric layer 104 and the second electrode 105.

It is to be noted that the position of the frequency trimming layer 109 may also be improved according to the design dimensions of the bulk acoustic wave resonance structure, which is not limited by the disclosure.

In some embodiments, the bulk acoustic wave resonance structure further includes a seed layer 110 located between the first electrode 103 and the substrate 101.

The first surrounding structure 107 is located between the seed layer 110 and the first electrode 103.

In a practical application, the bulk acoustic wave resonance structure further includes a seed layer 110 located between the first electrode 103 and the substrate 101. It is to be noted that, as illustrated in FIG. 14, before the first electrode 103 is deposited, a seed layer 110 may be deposited for improving the crystallographic axis orientation of the lower electrode material, such that the lattice is closer to the piezoelectric layer 104, and lattice defects in the subsequently deposited piezoelectric layer 104 are reduced. Further, the seed layer 110 may also be used as an etch blocking layer of the first electrode 103. The composition material of the seed layer 110 is the same as the composition material of the piezoelectric layer 104.

In an example, as illustrated in FIG. 14, the seed layer 110 is located between the first electrode 103 and the substrate 101, and the first protruding structure 171 is located between the piezoelectric layer 104 and the second electrode 105. In another example, the seed layer 110 is located between the first electrode 103 and the substrate 101, and the first protruding structure 171 is located between the seed layer 110 and the first electrode 103 (not shown).

In some embodiments, each of the first intermittent structures 172 is a groove.

The groove penetrates through at least one of the second electrode 105, a respective one of the first protruding structures 171, the piezoelectric layer 104, and the first electrode 103 in a direction perpendicular to the substrate 101.

Exemplarily, as illustrated in FIG. 3, the first intermittent structure 172 may be a groove that penetrates through the second electrode 105, the first protruding structure 171, the piezoelectric layer 104, and the first electrode 103. The grooves that are set around the first overlapping region 106 may reflect transverse shear waves in the first overlapping region 106, such that energy is concentrated in longitudinal waves in the first overlapping region 106 to suppress the transverse parasitic modes (i.e., suppress the parasitic resonance) and improve the Q value. It is to be noted that in case that a groove penetrates through the second electrode 105, the piezoelectric layer 104, and the first electrode 103 to be in contact with the sacrificial layer, the groove may be taken as an etching hole to etch the sacrificial layer to form a cavity-type reflection structure 102.

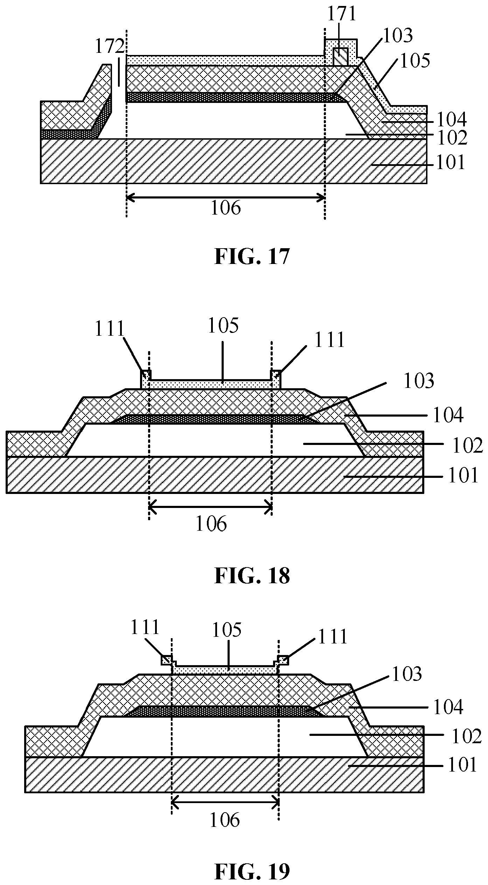

In an embodiment, as illustrated in FIG. 15, a part of the first protruding structures 171 are covered by the second electrode 105 and the second electrode lead. An end (remote from the first overlapping region 106) of the part of the first protruding structures 171 is flush with the edge of the second electrode 105. FIG. 16 is a local sectional schematic diagram of the bulk acoustic wave resonance structure illustrated according to FIG. 15 along the direction of the first intermittent structure. Exemplarily, as illustrated in FIG. 16, the first intermittent structure 172 penetrates through the second electrode 105, the first protruding structure 171, and a portion of the piezoelectric layer 104. FIG. 17 is another local sectional schematic diagram of the bulk acoustic wave resonance structure illustrated according to FIG. 15 along the direction of the first intermittent structure. Exemplarily, as illustrated in FIG. 17, the first intermittent structure 172 penetrates through the second electrode 105, the first protruding structure 171, the piezoelectric layer 104, and the first electrode 103.

It is to be noted that in case that the first intermittent structure 172 is a groove, the groove at least penetrates through the first protruding structure 171. The grooves located around the first overlapping region 106 may reflect transverse shear waves in the first overlapping region 106, such that energy is concentrated in longitudinal waves in the first overlapping region 106 to suppress the transverse parasitic modes (i.e., suppress the parasitic resonance) and improve the quality factor (Q value).

In some embodiments, the bulk acoustic wave resonance structure further includes frames 111 located on the second electrode 105 and connected to the second electrode 105.

The orthographic projection of each of the frames 111 on the substrate 101 falls into a region outside the first overlapping region 106, and the frames 111 are arranged at intervals around the first overlapping region 106.

In an example, referring to FIG. 18, the bulk acoustic wave resonance structure includes frames 111, and the frames 111 are located on the second electrode 105 and connected to the second electrode 105. Exemplarily, the composition materials of the frame 111 and the second electrode 105 are the same. The frames 111 form a mass-loaded structure. When a shear wave propagates to an overlapping region of the frames 111 and the second electrode 105, the transverse shear wave propagating to the region may be reflected and the leakage of the transverse shear wave may be suppressed, thereby improving the Q value of the bulk acoustic wave resonance structure.

In another example, referring to FIG. 19, the bulk acoustic wave resonance structure includes first protruding structures 171 and frames 111, and it is to be noted that FIG. 19 omits to show the first protruding structures 171. The first protruding structures 171 are located between the piezoelectric layer 104 and the second electrode 105, and an end adjacent to the first overlapping region 106 of each of the first protruding structures 171 is covered by the second electrode 105. The frames 111 are located on the second electrode 105 and connected to the second electrode 105, and the orthographic projection of a frame 111 on the substrate 101 at least partially overlaps with the orthographic projection of a respective first protruding structure 171 on the substrate 101. The first protruding structure 171 and the frame 111 are set such that the distance from the second electrode 105 to the first electrode 103 along the direction perpendicular to the substrate 101 becomes longer within the range of the orthographic projection of the first protruding structure 171 and the frame 111. In this way, the electric field line from the second electrode 105 to the first electrode 103 becomes longer, such that the electric field intensity close to the edge of the first overlapping region 106 becomes lower. Since the electric field intensity becomes lower, the electric displacement is reduced and the effect of piezoelectric resonance becomes lower, such that the parasitic resonance close to the edge of the first overlapping region 106 (i.e., which may be inside the first overlapping region 106 or outside the first overlapping region 106) is reduced to reduce the propagation of the parasitic resonance to the first overlapping region, thereby improving the Q value of the bulk acoustic wave resonance structure.

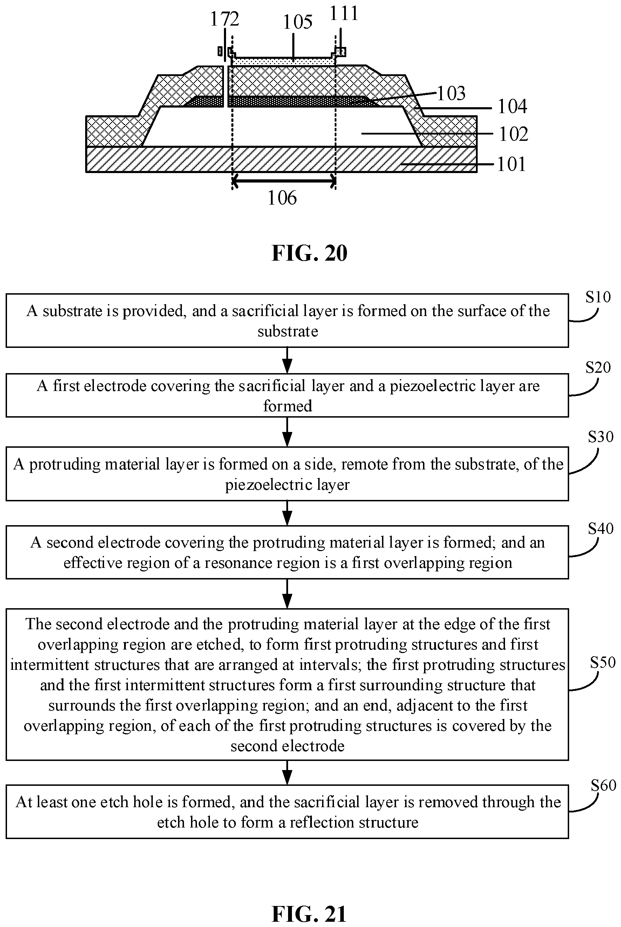

In yet another example, referring to FIG. 20, the bulk acoustic wave resonance structure includes a first surrounding structure 107 and frames 111. It is to be noted that the first surrounding structure 107 includes first protruding structures 171 and first intermittent structures 172 that are arranged at intervals, and FIG. 20 omits to show the first protruding structures 171. Exemplarily, as illustrated in FIG. 20, the first intermittent structure 172 may be a groove that penetrates through the frame 111, the second electrode 105, the first protruding structure 171, the piezoelectric layer 104, and the first electrode 103. The first intermittent structures 172 that are set around the first overlapping region 106 may reflect transverse shear waves in the first overlapping region 106, such that energy is concentrated in longitudinal waves in the first overlapping region 106 to suppress the transverse parasitic modes (i.e., suppress the parasitic resonance) and improve the Q value.

An embodiment of the disclosure provides an acoustic wave device including the bulk acoustic wave resonance structure according to the aforementioned embodiments. The acoustic wave device includes filters, duplexers, and multiplexers, but is not limited thereto.

In the embodiment of the disclosure, the specific illustration of the bulk acoustic wave resonance structure in the acoustic wave device may be referred to the bulk acoustic wave resonance structure in the aforementioned embodiments and will not be repeated herein.

FIG. 21 is a flowchart of a preparation method of a bulk acoustic wave resonance structure according to an embodiment of the disclosure. Based on the aforementioned bulk acoustic wave resonance structure, an embodiment of the disclosure provides a preparation method of a bulk acoustic wave resonance structure. The method includes the following operations.

In operation S10, a substrate is provided, and a sacrificial layer is formed on the surface of the substrate.

In operation S20, a first electrode covering the sacrificial layer and a piezoelectric layer are formed.

In operation S30, a protruding material layer is formed on a side (remote from the substrate) of the piezoelectric layer.

In operation S40, a second electrode covering the protruding material layer is formed. Here, an effective region of a resonance region is a first overlapping region.

In operation S50, the second electrode and the protruding material layer at the edge of the first overlapping region are etched, to form first protruding structures and first intermittent structures that are arranged at intervals. Here, the first protruding structures and the first intermittent structures form a first surrounding structure that surrounds the first overlapping region; and an end (adjacent to the first overlapping region) of each of the first protruding structures is covered by the second electrode.

In operation S60, at least one etch hole is formed, and the sacrificial layer is removed through the etch hole to form a reflection structure.

The composition materials of the substrate, the first electrode, the piezoelectric layer, the second electrode, and the reflection structure may be referred to the relevant description of the embodiments of the aforementioned bulk acoustic wave resonance structure and will not be repeated herein.

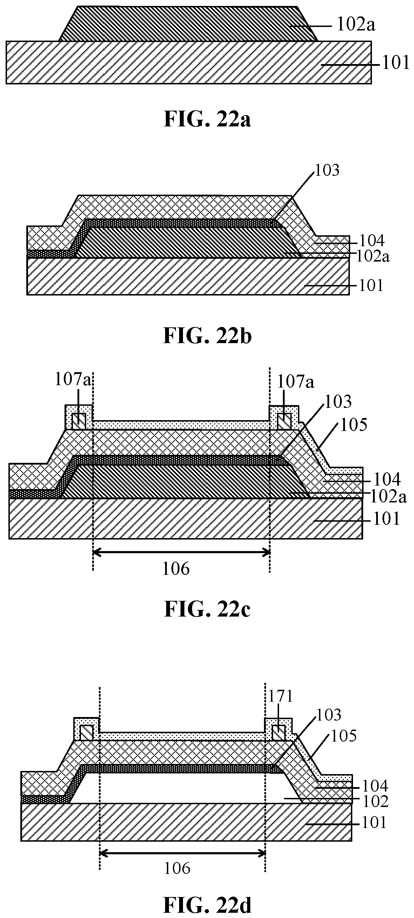

FIG. 22a to FIG. 22d are sectional schematic diagrams of a process of a preparation method of a bulk acoustic wave resonance structure according to an exemplary embodiment. Referring to FIG. 22a, the operation S10 is performed. In some embodiments, a sacrificial material is deposited on the substrate 101, and the sacrificial material is etched to form a sacrificial layer 102a. Exemplarily, the composition material of the sacrificial layer 102a includes phosphosilicate glass (PSG), silicon dioxide, or the like, but is not limited thereto. The case where the composition material of the sacrificial layer 102a is silicon dioxide is illustrated as an example. Silane (SiH₄) and oxygen (O₂) may be used as the reaction gas to form the sacrificial layer 102a on a first surface of the substrate 101 by a chemical vapor deposition process.

As illustrated in FIG. 22a, the sacrificial layer 102a may be formed on the substrate 101, and the sacrificial layer 102a protrudes from the upper surface of the substrate 101. The sacrificial layer 102a may be removed in a subsequent process to form an upwardly protruded cavity-type reflection structure 102 (refer to FIG. 22d).

Referring to FIG. 22b, the operation S20 is performed. A first electrode material covering the sacrificial layer 102a and the substrate 101 is formed, and the first electrode material is patterned to form a first electrode 103. As illustrated in FIG. 22b, a piezoelectric layer 104 covering the first electrode 103 is formed.

It is to be noted that before the first electrode 103 is deposited, a seed layer may be deposited for improving the crystallographic axis orientation of the lower electrode material, such that the lattice is closer to the piezoelectric layer, and lattice defects in the subsequently deposited piezoelectric layer are reduced. Further, the seed layer may also be used as an etch blocking layer of the first electrode 103. Exemplarily, the composition material of the seed layer is the same as the composition material of the piezoelectric layer 104.

Referring to FIG. 22c, the operations S30 to S40 are performed. A sacrificial material is deposited on a side (remote from the substrate 101) of the piezoelectric layer 104 to form a protruding material layer 107a. A second electrode material covering the protruding material layer 107a and the piezoelectric layer 104 is formed, and the second electrode material is patterned to form a second electrode 105. Exemplarily, the composition material of the protruding material layer 107a is the same as the composition material of the sacrificial layer 102a. It is to be noted that in an example, the protruding material layer 107a may be removed in a subsequent process to form air-type first protruding structures 171. In another example, the protruding material layer 107a may not be removed in a subsequent process to form first protruding structures 171 (refer to FIG. 22d).

Referring to FIG. 22d, the operation S50 is performed. In a practical application, the effective region of the resonance region is a first overlapping region 106. It is to be noted that FIG. 22d does not show first intermittent structures 172. Referring to FIG. 1 and FIG. 3, the second electrode 105 and the protruding material layer 107a at the edge of the first overlapping region 106 are etched, to form first protruding structures 171 and first intermittent structures 172 that are arranged at intervals. Here, the first protruding structures 171 and the first intermittent structures 172 form a first surrounding structure 107 that surrounds the first overlapping region 106; and an end (adjacent to the first overlapping region 106) of each of the first protruding structures 171 is covered by the second electrode 105.

Referring to FIG. 22d, the operation S60 is performed. At least one etch hole is formed, and the sacrificial layer 102a is removed through the etch hole to form a reflection structure 102. In an embodiment, etchant is released through the etch hole to remove the sacrificial layer 102a. The etch hole may penetrate through the piezoelectric layer 104 and the sacrificial layer 102a, until the surface of the substrate 101 is exposed. In another embodiment, the etch hole may only penetrate through the piezoelectric layer 104 until the surface of the sacrificial layer 102a is exposed, that is, the etch hole may not have to penetrate through the sacrificial layer 102a.

Exemplarily, suitable etchant may be selected and injected into the etch hole, such that the etchant contacts and chemically reacts with the exposed sacrificial layer 102a to produce a gaseous product, and then the sacrificial layer 102a is removed.

Specifically, in case that the composition material of the sacrificial layer 102a is silicon dioxide, a dry etching process may be adopted, and hydrogen fluoride (HF) may be selected as the etchant to remove the sacrificial layer 102a. After hydrogen fluoride reacts with the sacrificial layer 102a exposed through the etch hole, gaseous silicon fluoride (SiF₄) and gaseous water are produced.

In some embodiments, the method further includes the following operation. The second electrode 105 is thinned. The frequency modulation of the bulk acoustic wave resonance structure may be further performed by thinning,

In the embodiments of the disclosure, by the first protruding structures 171 surrounding the first overlapping region 106, the distance between the first electrode 103 and the second electrode 105 at the edge of the first overlapping region 106 may be increased, thereby reducing the electric field intensity at the edge of the first overlapping region 106. Since the electric field intensity is reduced, the electric displacement is reduced and the effect of piezoelectric resonance becomes lower, which may reduce the parasitic resonance at the edge of the first overlapping region 106 to reduce the propagation of the parasitic resonance to the first overlapping region 106, thereby improving the quality factor (Q value) of the bulk acoustic wave resonance structure. In addition, the first intermittent structures 172 surrounding the first overlapping region 106 may reflect transverse shear waves in the first overlapping region 106, such that energy is concentrated in longitudinal waves in the first overlapping region 106 to suppress the transverse parasitic modes (i.e., suppress the parasitic resonance) and increase the Q value.

Based on the aforementioned bulk acoustic wave resonance structure, an embodiment of the disclosure provides another preparation method of a bulk acoustic wave resonance structure. The method includes the following operations.

In first operation, a substrate is provided, and a sacrificial layer is formed on the surface of the substrate.

In second operation, a first electrode covering the sacrificial layer is formed.

In third operation, a protruding material layer is formed on the first electrode.

In fourth operation, a piezoelectric layer covering the protruding material layer and the first electrode is formed.

In fifth operation, a second electrode covering the piezoelectric layer is formed. Here, an effective region of a resonance region is a first overlapping region.

In sixth operation, the second electrode, the piezoelectric layer, and the protruding material layer at the edge of the first overlapping region are etched, to form first protruding structures and first intermittent structures that are arranged at intervals. Here, the first protruding structures and the first intermittent structures form a first surrounding structure that surrounds the first overlapping region; and an end (adjacent to the first overlapping region) of each of the first protruding structures is covered by the first electrode.

In seventh operation, at least one etch hole is formed, and the sacrificial layer is removed through the etch hole to form a reflection structure.

It is to be noted that the specific process of forming the substrate 101, the reflection structure 102, the first electrode 103, the piezoelectric layer 104, and the second electrode 105 in the first operation to the seventh operation may be referred to the description in the aforementioned flowchart of the operations S10 to S60.

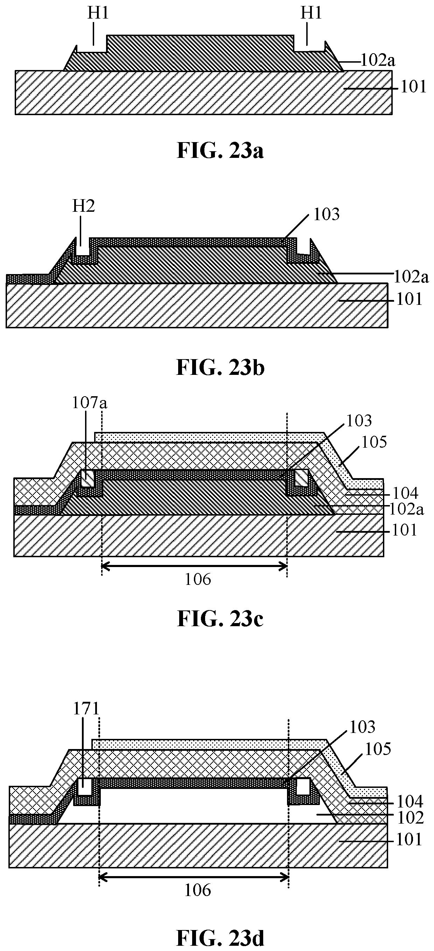

FIG. 23a to FIG. 23d are sectional schematic diagrams of a process of a preparation method of a bulk acoustic wave resonance structure according to an embodiment of the disclosure. Referring to FIG. 23a, the first operation is performed. In some embodiments, a sacrificial material is deposited on the substrate 101, the sacrificial material is etched to form a sacrificial layer 102a, and the sacrificial layer 102a is etched to form first grooves H1. As illustrated in FIG. 23a, the sacrificial layer 102a may be formed on the substrate 101, and the sacrificial layer 102a protrudes from the upper surface of the substrate 101. The sacrificial layer 102a may be removed in a subsequent process to form an upwardly protruded cavity-type reflection structure 102 (refer to FIG. 23d).

Referring to FIG. 23b, the second operation is performed. A first electrode material is deposited and the first electrode material is patterned to form a first electrode 103. The first electrode 103 is etched to form second groove(s) H2. The etching processes includes dry etching and wet etching, but are not limited thereto. As illustrated in FIG. 23b, in an example, the second groove H2 is formed in the first electrode 103 by the etching process. In another example, due to the morphological features of the first groove H1 in the sacrificial layer 102a, the second groove H2 is formed while the first electrode 103 is formed by deposition.

Referring to FIG. 23c, the third operation is performed. A sacrificial material is deposited in the second groove H2, and the sacrificial material is etched to form a protruding material layer 107a. Exemplarily, the composition material of the protruding material layer 107a is the same as the composition material of the sacrificial layer 102a. It is to be noted that in an example, the protruding material layer 107a may be removed in a subsequent process to form first protruding structures 171 consisting of air (not shown). In another example, the protruding material layer 107a may not be removed in a subsequent process to form first protruding structures 171 consisting of a sacrificial material such as silicon dioxide (refer to FIG. 23d).

Referring to FIG. 23c, the fourth operation to the fifth operation are performed. A piezoelectric layer 104 covering the protruding material layer 107a and the first electrode 103 is formed. A second electrode material covering the piezoelectric layer 104 is formed, and the second electrode material is patterned to form a second electrode 105.

Referring to FIG. 23d, the sixth operation is performed. In a practical application, the effective region of the resonance region is a first overlapping region 106. It is to be noted that FIG. 23d does not show first intermittent structures 172. Referring to FIG. 1 and FIG. 10, the second electrode 105, the piezoelectric layer 104, and the protruding material layer 107a at the edge of the first overlapping region 106 are etched, to form first protruding structures 171 and first intermittent structures 172 that are arranged at intervals. Here, the first protruding structures 171 and the first intermittent structures 172 form a first surrounding structure 107 that surrounds the first overlapping region 106; and an end (adjacent to the first overlapping region 106) of each of the first protruding structures 171 is covered by the first electrode 103.

Referring to FIG. 23d, the seventh operation is performed. At least one etch hole is formed, and the sacrificial layer 102a is removed through the etch hole to form a reflection structure 102. The specific process of the seventh operation may be referred to the description of the operation S60 in the flowchart illustrated in FIG. 21 and will not be repeated herein.

In the embodiments of the disclosure, by the first protruding structures 171 surrounding the first overlapping region 106, the distance between the first electrode 103 and the second electrode 105 at the edge of the first overlapping region 106 may be increased, thereby reducing the electric field intensity at the edge of the first overlapping region 106. Since the electric field intensity is reduced, the electric displacement is reduced and the effect of piezoelectric resonance becomes lower, which may reduce the parasitic resonance at the edge of the first overlapping region 106 to reduce the propagation of the parasitic resonance to the first overlapping region 106, thereby improving the quality factor (Q value) of the bulk acoustic wave resonance structure. In addition, the first intermittent structures 172 surrounding the first overlapping region 106 may reflect transverse shear waves in the first overlapping region 106, such that energy is concentrated in longitudinal waves in the first overlapping region 106 to suppress the transverse parasitic modes (i.e., suppress the parasitic resonance) and increase the Q value.

Based on the aforementioned bulk acoustic wave resonance structure, an embodiment of the disclosure provides yet another preparation method of a bulk acoustic wave resonance structure. The method includes the following operations.

In first operation, a substrate is provided, and a sacrificial layer is formed on the surface of the substrate.

In second operation, a first electrode covering the sacrificial layer and a piezoelectric layer are formed.

In third operation, sacrificial material structures and first intermittent structures that are arranged at intervals are formed on a side (remote from the substrate) of the piezoelectric layer.

In fourth operation, a second electrode covering the sacrificial material structures and the first intermittent structures is formed. Here, an effective region of a resonance region is a first overlapping region.

In fifth operation, at least one etch hole is formed, and the sacrificial material structures and the sacrificial layer are removed through the etch hole, to form first protruding structures and a reflection structure respectively. Here, the first protruding structures and the first intermittent structures form a first surrounding structure that surrounds the first overlapping region; and an end (adjacent to the first overlapping region) of each of the first protruding structures is covered by the second electrode.

It is to be noted that the specific process of forming the substrate 101, the reflection structure 102, the first electrode 103, the piezoelectric layer 104, and the second electrode 105 in the first operation to the fifth operation may be referred to the description in the aforementioned flowchart of the operations S10 to S60.

Referring to FIG. 22a, the first operation is performed. In some embodiments, a sacrificial material is deposited on the substrate 101, and the sacrificial material is etched to form a sacrificial layer 102a. As illustrated in FIG. 22a, the sacrificial layer 102a may be formed on the substrate 101, and the sacrificial layer 102a protrudes from the upper surface of the substrate 101. The sacrificial layer 102a may be removed in a subsequent process to form an upwardly protruded cavity-type reflection structure 102.

Referring to FIG. 22b, the second operation is performed. A first electrode material is deposited and the first electrode material is patterned to form a first electrode 103. A piezoelectric layer 104 covering the first electrode 103 is formed.

The third operation is performed. Sacrificial material structures and first intermittent structures 172 that are arranged at intervals are formed on a side (remote from the substrate 101) of the piezoelectric layer 104 (refer to FIG. 7). It is to be noted that in an example, the sacrificial material structures may be removed in a subsequent process to form air-type first protruding structures 171. In another example, the protruding material layer 107a may not be removed in a subsequent process to form first protruding structures 171 (refer to FIG. 7). It is to be noted that by forming intermittent first protruding structures 171, the process of etching to form the first intermittent structures 172 may be reduced. The composition material of the intermittent first protruding structures 171 may be air, the protrusion is air, and the material of the upper electrode (the second electrode 105) is at the first intermittent structures 172.

The fourth operation is performed. A second electrode material covering the sacrificial material structures and the first intermittent structures 172 is formed, and the second electrode material is patterned to form a second electrode 105. In a practical application, the effective region of the resonance region is a first overlapping region 106.

The fifth operation is performed. At least one etch hole is formed, and the sacrificial material structures and the sacrificial layer 102a are removed through the etch hole, to form first protruding structures 171 and a reflection structure 102 respectively. Here, the first protruding structures 171 and the first intermittent structures 172 form a first surrounding structure 107 that surrounds the first overlapping region 106; and an end (adjacent to the first overlapping region 106) of each of the first protruding structures 171 is covered by the second electrode 105. The specific process of removing through the etch hole in the fifth operation may be referred to the description of the operation S60 in the flowchart illustrated in FIG. 21 and will not be repeated herein.

In the embodiments of the disclosure, by the first protruding structures 171 surrounding the first overlapping region 106, the distance between the first electrode 103 and the second electrode 105 at the edge of the first overlapping region 106 may be increased, and the parasitic resonance at the edge of the first overlapping region 106 may be reduced, to reduce the propagation of the parasitic resonance to the first overlapping region 106, thereby improving the quality factor (Q value) of the bulk acoustic wave resonance structure. The first intermittent structures 172 surrounding the first overlapping region 106 may reflect transverse shear waves in the first overlapping region 106, to suppress the transverse parasitic modes (i.e., suppress the parasitic resonance) and increase the Q value. In addition, by forming intermittent first protruding structures 171, the process of etching to form the first intermittent structures 172 may be reduced, thereby reducing the process steps, simplifying the preparation process, and saving the cost.

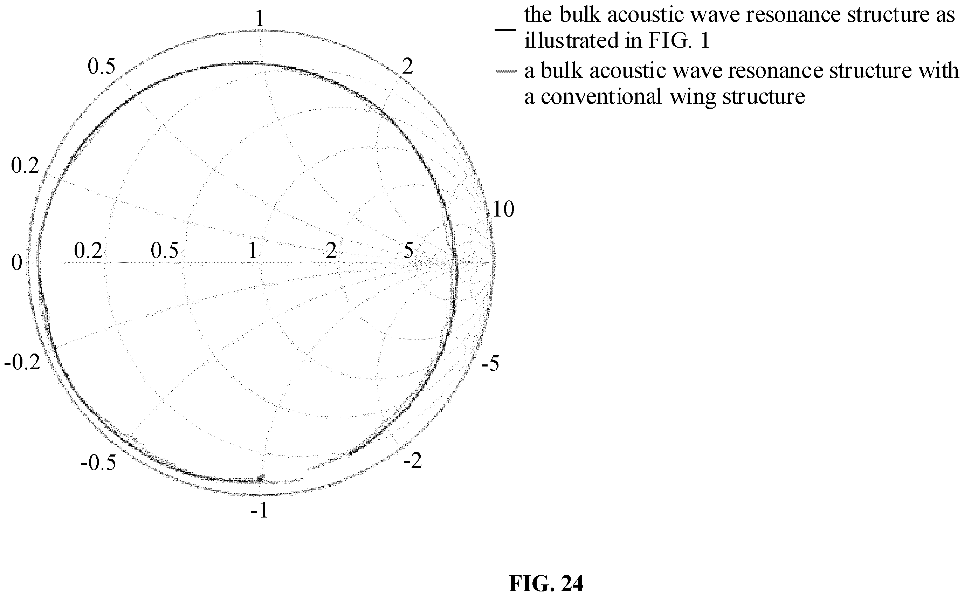

It is to be noted that, according to the simulation test, Smith chart test results of the bulk acoustic wave resonance structure as illustrated in FIG. 1 and a bulk acoustic wave resonance structure with a conventional wing structure are respectively illustrated in FIG. 24. As illustrated in FIG. 24, the Smith circle of the bulk acoustic wave resonance structure as illustrated in FIG. 1 is smoother. Therefore, compared to the bulk acoustic wave resonance structure with the conventional wing structure, the bulk acoustic wave resonance structure as illustrated in FIG. 1 in the embodiments of the disclosure has a better device performance.

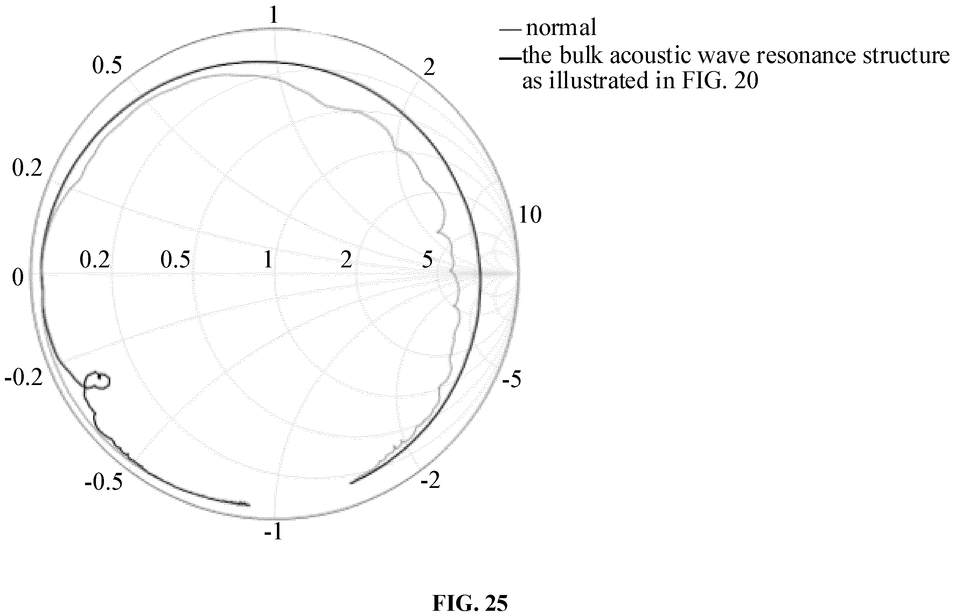

According to the simulation test, Smith chart test results of the bulk acoustic wave resonance structure as illustrated in FIG. 20 and a normal bulk acoustic wave resonance structure are respectively illustrated in FIG. 25. The normal bulk acoustic wave resonance structure indicates that a wing structure, a Frame structure, and a groove are not set in a bulk acoustic wave resonance structure. As illustrated in FIG. 25, the Smith circle of the bulk acoustic wave resonance structure as illustrated in FIG. 20 is smoother. Therefore, compared to the normal bulk acoustic wave resonance structure, the bulk acoustic wave resonance structure as illustrated in FIG. 20 in the embodiments of the disclosure has a better device performance.

It is to be understood that "an embodiment" or "some embodiments" throughout the specification mean that a particular feature, structure or characteristic associated with the embodiment is included in at least one embodiment of the disclosure. Thus, "in an embodiment" or "in some embodiments" appearing throughout the specification do not necessarily refer to the same embodiment. In addition, these particular features, structures or characteristics may be combined in one or more embodiments in any suitable manner. It is to be understood that in the various embodiments of the disclosure, the serial numbers of the aforementioned processes do not imply the order of execution. The order of execution of the processes should be determined by their function and inherent logic, and should not constitute any limitation on the implementation processes of the embodiments of the disclosure. The above serial numbers of the embodiments of the disclosure are only for description and do not represent the advantages and disadvantages of the embodiments.

The above is only the specific implementations of the disclosure, but the scope of protection of the disclosure is not limited thereto. Any variations or replacements apparent to those skilled in the art within the technical scope disclosed by the disclosure shall fall within the scope of protection of the disclosure.

## Claims

1. A bulk acoustic wave resonance structure, comprising:
a substrate;
a reflection structure, a first electrode, a piezoelectric layer and a second electrode that are sequentially located on the substrate; wherein an effective region of a resonance region is a first overlapping region; and
a first surrounding structure that surrounds the first overlapping region, wherein the first surrounding structure comprises first protruding structures and first intermittent structures that are arranged at intervals;
wherein the first protruding structures are located between the piezoelectric layer and the first electrode, and/or, between the piezoelectric layer and the second electrode; and an end, adjacent to the first overlapping region, of each of the first protruding structures is covered by the first electrode and/or the second electrode.

2. The bulk acoustic wave resonance structure of claim 1, wherein in case that the first protruding structures are only located between the piezoelectric layer and the second electrode, the bulk acoustic wave resonance structure further comprises a second surrounding structure that surrounds the first surrounding structure; and
the second surrounding structure partially covers a sidewall remote from the reflection structure of the piezoelectric layer.

3. The bulk acoustic wave resonance structure of claim 2, wherein a material of the second surrounding structure is the same as a material of the first protruding structures, and the second surrounding structure is connected to the first protruding structures to form an integral structure.

4. The bulk acoustic wave resonance structure of claim 2, wherein the second surrounding structure comprises second protruding structures and second intermittent structures that are arranged at intervals; the first intermittent structures and the second intermittent structures are gaps; a material of the second protruding structures is the same as a material of the first protruding structures, and each of the second protruding structures is connected to a respective one of the first protruding structures to form an integral structure.

5. The bulk acoustic wave resonance structure of claim 1, wherein in case that the first protruding structures are only located between the piezoelectric layer and the second electrode, the end adjacent to the first overlapping region and another end remote from the first overlapping region of the first protruding structure are covered by the second electrode; and
the first protruding structure comprises a top and a bottom that are opposite in a direction perpendicular to the substrate, the top is in direct contact with the second electrode, and the bottom is in direct contact with the piezoelectric layer.

6. The bulk acoustic wave resonance structure of claim 1, wherein in case that the first protruding structures are only located between the piezoelectric layer and the first electrode, the end adjacent to the first overlapping region and another end remote from the first overlapping region of the first protruding structure are covered by the first electrode; and
the first protruding structure comprises a top and a bottom that are opposite in a direction perpendicular to the substrate, the top is in direct contact with the piezoelectric layer, and the bottom is in direct contact with the first electrode.

7. The bulk acoustic wave resonance structure of claim 1, wherein the first protruding structure comprises a first substructure and a second substructure;
the first substructure is only located between the piezoelectric layer and the second electrode, and an end adjacent to the first overlapping region and another end remote from the first overlapping region of the first substructure are covered by the second electrode;
the second substructure is only located between the piezoelectric layer and the first electrode, and an end adjacent to the first overlapping region and another end remote from the first overlapping region of the second substructure are covered by the first electrode; and
an orthographic projection of the first substructure on the substrate at least partially overlaps with an orthographic projection of the second substructure on the substrate.

8. The bulk acoustic wave resonance structure of claim 1, wherein a distance between the end adjacent to the first overlapping region of the first protruding structure and an edge of the first overlapping region in a first direction is 0 µm to 10 µm; and the first direction is a direction from the edge of the first overlapping region toward a center of the first overlapping region.

9. The bulk acoustic wave resonance structure of claim 1, further comprising a first electrode lead and a second electrode lead, wherein the first electrode lead is connected to the first electrode and the second electrode lead is connected to the second electrode;
an orthographic projection of the first electrode lead on the substrate and an orthographic projection of the second electrode lead on the substrate are located in a region outside the first overlapping region; and
an orthographic projection of the first intermittent structure on the substrate falls into a region outside the orthographic projection of the first electrode lead on the substrate and the orthographic projection of the second electrode lead on the substrate.

10. The bulk acoustic wave resonance structure of claim 1, further comprising a frequency trimming layer located on the second electrode;
wherein the first surrounding structure is located between the frequency trimming layer and the second electrode.

11. The bulk acoustic wave resonance structure of claim 1, further comprising a seed layer located between the first electrode and the substrate;
wherein the first surrounding structure is located between the seed layer and the first electrode.

12. The bulk acoustic wave resonance structure of claim 1, wherein each of the first intermittent structures is a groove; and
the groove penetrates through at least one of the second electrode, a respective one of the first protruding structures, the piezoelectric layer, or the first electrode in a direction perpendicular to the substrate.

13. The bulk acoustic wave resonance structure of claim 1, further comprising frames located on the second electrode and connected to the second electrode;
wherein an orthographic projection of each of the frames on the substrate falls into a region outside the first overlapping region, and the frames are arranged at intervals around the first overlapping region.

14. An acoustic wave device, comprising the bulk acoustic wave resonance structure of any one of claims 1 to 13.

15. A preparation method of a bulk acoustic wave resonance structure, comprising:
providing a substrate, and forming a sacrificial layer on a surface of the substrate;
forming a first electrode covering the sacrificial layer, and forming a piezoelectric layer;
forming a protruding material layer on a side, remote from the substrate, of the piezoelectric layer;
forming a second electrode covering the protruding material layer; wherein an effective region of a resonance region is a first overlapping region;
etching the second electrode and the protruding material layer at an edge of the first overlapping region, to form first protruding structures and first intermittent structures that are arranged at intervals; wherein the first protruding structures and the first intermittent structures form a first surrounding structure that surrounds the first overlapping region; and an end, adjacent to the first overlapping region, of each of the first protruding structures is covered by the second electrode; and
forming at least one etch hole, and removing the sacrificial layer through the etch hole to form a reflection structure.

16. A preparation method of a bulk acoustic wave resonance structure, comprising:
providing a substrate, and forming a sacrificial layer on a surface of the substrate;
forming a first electrode covering the sacrificial layer;
forming a protruding material layer on the first electrode;
forming a piezoelectric layer covering the protruding material layer and the first electrode;
forming a second electrode covering the piezoelectric layer; wherein an effective region of a resonance region is a first overlapping region;
etching the second electrode, the piezoelectric layer, and the protruding material layer at an edge of the first overlapping region, to form first protruding structures and first intermittent structures that are arranged at intervals; wherein the first protruding structures and the first intermittent structures form a first surrounding structure that surrounds the first overlapping region; and an end, adjacent to the first overlapping region, of each of the first protruding structures is covered by the first electrode; and
forming at least one etch hole, and removing the sacrificial layer through the etch hole to form a reflection structure.

17. A preparation method of a bulk acoustic wave resonance structure, comprising:
providing a substrate, and forming a sacrificial layer on a surface of the substrate;
forming a first electrode covering the sacrificial layer, and a piezoelectric layer;
forming sacrificial material structures and first intermittent structures that are arranged at intervals on a side, remote from the substrate, of the piezoelectric layer;
forming a second electrode covering the sacrificial material structures and the first intermittent structures; wherein an effective region of a resonance region is a first overlapping region; and
forming at least one etch hole; and removing the sacrificial material structures and the sacrificial layer through the etch hole to form first protruding structures and a reflection structure respectively; wherein the first protruding structures and the first intermittent structures form a first surrounding structure that surrounds the first overlapping region; and an end, adjacent to the first overlapping region, of each of the first protruding structures is covered by the second electrode.
